Europäisches Patentamt

**European Patent Office**

**Office européen des brevets**

(11) Publication number: **0 059 537**
**A2**

(12) # EUROPEAN PATENT APPLICATION

(21) Application number: **82300593.9**

(22) Date of filing: **05.02.82**

(51) Int. Cl.³: **H 03 K 17/04**

(30) Priority: **26.02.81 US 238308**

(43) Date of publication of application:
**08.09.82 Bulletin 82/36**

(84) Designated Contracting States:
**DE FR GB**

(71) Applicant: **CONTROL DATA CORPORATION**
**8100-34th Avenue South**
**Minneapolis Minnesota 55440(US)**

(72) Inventor: **Grosz, William Stewart**
**5240 Shady Island Circle**
**Mound Minnesota(US)**

(74) Representative: **Caro, William Egerton et al,**
**J. MILLER & CO. Lincoln House 296-302 High Holborn**
**London WC1V 7JH(GB)**

(54) **Switching circuit.**

(57) A switching circuit comprises a switching transistor (26) having a base (28), an emitter (24) and a collector (34), a transformer (18) having a primary winding (20) and a secondary winding (22) one end (12) of which is coupled to the emitter and the other end (16) of which is coupled through a diode (30) to the collector. A resistor (36) is connected between the base and the emitter. The secondary winding (22) has a centre tap (14) connected to the base of the transistor. The diode (30) is arranged to conduct current into the collector and divert current available to the base emitter junction to prevent the collector base junction from being forward biased.

Fig. 6

EP 0 059 537 A2

- 1 -

"SWITCHING CIRCUIT"

This invention relates to switching circuits, and in particular, although not so restricted, to drive circuits for switching DC power supplies.

A phenomenon known as "storage time delay" occurs when a forward bias appears across the collector-base junction of a transistor. Excess minority carriers accumulate in the base such that even after the base drive has been removed, the transistor remains conductive until the excess minority carriers are dissipated. In power applications where the transistor is used as a switch it is highly desirable to minimise storage time to make possible accurate control of transistor conduction time.

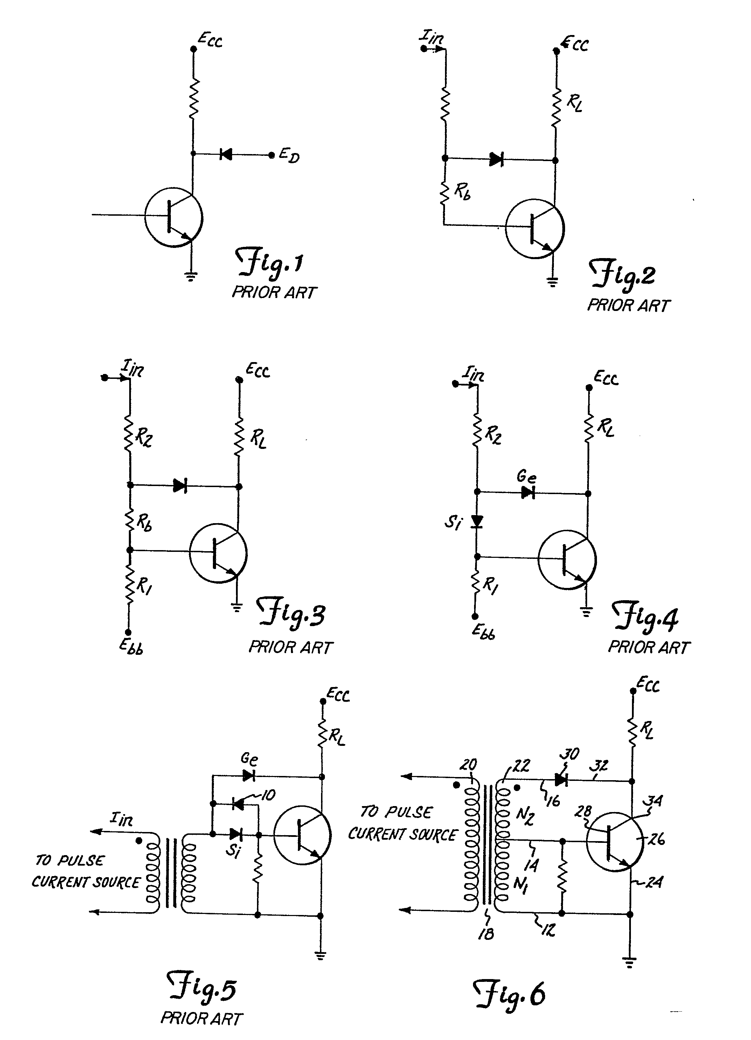

There are several known approaches to reduce storage time some of which are illustrated in Figures 1 to 5. Each of these approaches has its own particular disadvantage. One approach may require an alternate collector or bias supply. Another approach may require a resistor or a diode in the base connection which dissipates energy in the form of heat.

According to the present invention there is provided a switching circuit comprising a switching transistor having a base, an emitter and a collector, a transformer having a primary winding and a secondary winding one end of which is coupled to the emitter and the other end of which is coupled through a diode to a collector, and a resistor connected between said base and said emitter characterised in that the secondary winding has a centre tap connected to the base of said transistor, said diode being arranged to conduct current into the collector and divert current available to the base emitter junction to prevent the collector base junction from becoming forward biased.

The invention is illustrated, merely by way of example, in the accompanying drawings, in which:-

Figure 1 shows a known switching circuit designed to avoid saturation;

Figure 2 shows a known switching circuit without a bias supply;

Figure 3 shows a known switching circuit with a bias supply;

Figure 4 shows a known switching circuit with a bias supply using germanium and silicon diodes;

Figure 5 shows a known switching circuit using germanium and silicon diodes;  and

Figure 6 shows one embodiment of a switching circuit according to the present invention.

Figures 1 to 5 show known collector clamping or switching circuits to reverse bias the collector-base junction of a transistor to decrease the storage time delay on turn-off. Figure 5 shows a known circuit referred to as a Baker clamp and described in "How to Increase Switching Speed" by Baker (Electronics, March 1957, page 50).  The circuit uses the potential drop across a silicon diode Si relative to the potential drop across a germanium diode Ge to maintain the collector-base junction reverse biased.

This known circuit is inefficient insofar as there is a resistive drop across the silicon diode in the base drive. It is also further complicated when a third diode 10 is included to conduct the reverse bias current.

One embodiment of a transformer-coupled anti-saturation switching circuit according to the present invention is shown in Figure 6 and eliminates the need for a base drive resistor, thereby increasing overall circuit efficiency.  Another advantage of the switching circuit of Figure 6 is that it is more flexible in selecting collector-to-emitter "on" voltage, $V_{CE}$.  In Figure 5, the voltage $V_{CE}$ is equal to the base emitter voltage, $V_{BE}$, plus the voltage $V_{F1}$ across the germanium diode minus the voltage $V_{F2}$

across the silicon diode, namely:

$$V_{CE} = V_{BE} + V_{F1} - V_{F2}$$

This may not be optimum.

In the switch circuit of Figure 6, the collector-emitter voltage is:

$$V_{CE} = V_{BE} \frac{(N_1 + N_2)}{N_1} - V_{F1}$$

where $V_{F1}$ is the potential drop across a diode 32, $N_1$ is the number of turns between a lower end 12 of a secondary winding 22 of a transformer 18 and a centre tap 14, and $N_2$ is the number of turns between the centre tap 14 and an upper end 16 of the secondary winding.

The transformer 18 has a primary 20 connected, in switching applications, to a pulse source (not shown) of current $I_{IN}$.

The end 12 of the secondary winding is connected to the emitter 24 of a switching transistor 26. The centre tap 14 is connected to a base 28 of the transistor and the other end 16 of the secondary winding is connected to one side of a PN diode 30. In the illustrated embodiment the transistor 26 is of the NPN type. When the transistor is of the PNP type, the end 16 is connected to the other side of the diode 30.

The other side 32 of the diode 30 is connected to the collector of the transistor 34. A resistor 36 provides a conduction path for the decaying magnetic field in the secondary winding 22 after the base-emitter junction of the transistor has become reverse-biased. A power line in which the transistor 26 operates is shown generally as a voltage source Ecc, a load $R_L$ and ground.

In operation, an appropriately polarized pulse flowing through the primary winding of the transformer will induce in the secondary winding 22 a positive voltage between the end 12 and the centre tap 14, forward biasing the base-emitter junction of the transistor 26 rendering it conductive. The same pulse generates an even more positive voltage at the end 16 of the secondary winding, which, after the potential drop across the diode 30, maintains the collector-base junction reverse-biased and prevents the collector-base junction from being forward-biased. It will be appreciated that these voltages may be adjusted such that the transistor is rendered conductive just below the point of saturation. Turn-off time is thereby minimized while circuit efficiency is increased.

CLAIM

A switching circuit comprising a switching transistor
(26) having a base (28), an emitter (24) and a collector (34),
a transformer (18) having a primary winding (20) and a secondary
winding (22) one end (12) of which is coupled to the emitter and
the other end (16) of which is coupled through a diode (30) to
the collector, and a resistor (36) connected between said base
and said emitter characterised in that the secondary winding (22)
has a centre tap (14) connected to the base of said transistor,
said diode (30) being arranged to conduct current into the
collector and divert current available to the base emitter
junction to prevent the collector base junction from becoming
forward biased.

*Fig.1*
PRIOR ART

*Fig.2*
PRIOR ART

*Fig.3*
PRIOR ART

*Fig.4*
PRIOR ART

*Fig.5*
PRIOR ART

*Fig.6*